# EUROPEAN PATENT APPLICATION

(11) **EP 3 886 146 A1**
(43) Date of publication of application: **29.09.2021**
(21) Application number: 20164970.4
(22) Date of filing: 23.03.2020
(51) Int. Cl.: H01L 21/48, H01L 23/473

(54) **HEAT SINK**

(71) Applicant: Arrival Limited, London W14 8TS (GB)
(72) Inventor: BIKMUKHAMETOV, Alexey, 197229 Saint Petersburg (RU)
(74) Representative: Korenberg, Alexander Tal

(57) **Abstract**

The present invention relates to a heat sink, for example, for cooling an electronic device including electronic power switches such as IGBTs. The heat sink includes an upper part and a lower part and comprises multiple coolant channels, each defining a path for a coolant flow from an inlet manifold to an outlet manifold to transfer heat from a heat-transfer surface. Each of the coolant channels comprises cavities formed alternatingly in the upper part and the lower part of the heat sink, the cavities being successively connected to each other by overlapping sides thereof, wherein an overlap between any two successive cavities has smaller cross-sectional area than the cavities. The invention allows increasing the heat sink efficiency while keeping its size compact.

## Description

### TECHNICAL FIELD

The present invention relates to a heat sink, for example, for cooling an electronic device including power elements such as an inverter including insulated-gate bipolar transistors (IGBTs).

### BACKGROUND

There is an ever-increasing demand for cooling means in the electronics industry. One of the most pressing challenges in this field relates to cooling high-power inverters. Namely, the underlying challenge is the fact that conflicting requirements are imposed on a design of an inverter. For example, variable control of rotation speed of an electric motor in an electrical vehicle (EV) requires a high-power inverter featuring compact and light-weight design. In other words, the inverter shall handle as much power as possible with a power board of as small as possible size. To that end, required is an effective and compact cooling means for the inverter power board typically comprising tens of IGBTs.

Known is a heat sink as described in US 7,522,422 B2 (published on April 21, 2009) for cooling a power semiconductor module, e.g. an inverter incorporating IGBTs. The known heat sink consists of a flow base member and a heat sink body, forming in cooperation a coolant flow passage, and a bellows-like flow straightening plate, disposed between and in physical contact with a heat transfer surface and the base member, dividing the coolant flow passage into a plurality of flow straightening channels that include base member-side channels and heat transfer-side channels, wherein the base member-side channels are provided with ribs to cause turbulence of the coolant flow and with through-holes, connecting adjacent flow straightening channels with each other, to cause turbulent interchannel flows of the coolant.

Due to the flow straightening plate structure, the cooling efficiency in the known heat sink is uniformized across the heat transfer surface area. However, this solution fails to provide uniform cooling along the heat sink body: the coolant is gradually heated during its propagation along every flow straightening channel so that IGBTs positioned on the coolant outlet side of the heat sink experience less cooling than IGBTs on the inlet side. It is well-known that the cooling efficiency of a heat sink is defined by its minimal cooling capacity observed on the coolant outlet side of the heat sink. An increase in a number and/or a power of to-be cooled IGBTs would require increasing the size of the known heat sink to increase the coolant flow volume and the flow straightening plate area which is brought into contact with the coolant flow. Another approach can consist in increasing the coolant flow velocity, but it is much more expensive solution. As a result, a high-power inverter, for example, the one with tens of IGBTs, would require a large-sized heat sink as described above.

The present invention is directed to solving the prior art problems mentioned above, in particular, by providing a compact heat sink with an enhanced efficiency.

### SUMMARY OF THE INVENTION

There is provided a heat sink including an upper part and a lower part, with at least the upper part having a heat-transfer surface, the heat sink comprising multiple coolant channels, each defining a path for a coolant flow from an inlet manifold to an outlet manifold to transfer heat from the heat-transfer surface. Each of the coolant channels comprises cavities formed alternatingly in the upper part and the lower part of the heat sink, the cavities being successively connected to each other by overlapping sides thereof, wherein an overlap between any two successive cavities have smaller cross-sectional area than the cavities.

In the heat sink according to the present disclosure the cooling efficiency is increased and uniformized over the whole heat-transfer surface area. The coolant is brought into contact with the heat-transfer surface when it propagates through the upper part cavities of every coolant channel, while in the lower part cavities the coolant flow transfers a part of the collected heat to the lower part of the heat sink and further to the coolant flows in the adjacent channels. The efficiency of heat transfer in both cases is increased by means of the design of the overlaps between the cavities that operate as nozzles increasing the coolant flow velocity at the entrance of every cavity in every coolant channel.

Moreover, the overlaps between the cavities having smaller cross-sectional area, define a hydraulic resistance of the coolant channel. Such design of the coolant channels enables uniform filing of all the channels by the coolant as well as the same average velocity of the coolant flow in every channel. In such a way, the heat, transferred from the heat-transfer surface, is distributed much more uniformly over the heat sink volume and a difference between the inlet and outlet coolant temperature is decreased significantly. Furthermore, the heat sink of the present disclosure, essentially consisting of two parts, is easy to manufacture, assemble and maintain.

The above benefits are developed in embodiments as described below.

In some embodiments, the coolant channels adjacent to each other in the transverse direction of the heat sink are made in an antiphase manner. That is, in a cross section of the heat sink the cavities constituting the coolant channels are checkerboard-arranged in the upper and lower parts of the heat sink. With these embodiments, the heat transfer and distribution are further increased and uniformized over the heat sink volume.

According to further embodiments, the coolant channels are made of the same width and adjacent to each other in the transverse direction of the heat sink so that the whole heat-transfer area of the heat sink is occupied with the coolant channels. It allows reducing sizes of the heat sink.

In further embodiments, the lower part of the heat sink has another heat-transfer surface. Such symmetry of the heat sink design allows increasing the cooling efficiency by interchanging the heat from the heat-transfer surfaces between the upper and lower parts of the heat sink.

In some embodiments, the inlet manifold and the outlet manifold of the heat sink comprise cavities formed in the lower part and/or the upper part of the heat sink extending in the transverse direction thereof so that to pass through all the coolant channels. At that, the cavities constituting the inlet manifold and the outlet manifold can be formed in place of (and thereby overlapping) the cavities constituting the coolant channels so that the manifolds are arranged within the heat-transfer area of the heat sink. It allows further reducing the size of the heat sink.

According to further embodiments, each of the coolant channels comprises the same number of cavities in the upper part as in the lower part of the heat sink. Such symmetry of the design simplifies the heat sink manufacture and enhances the heat distribution over the heat sink volume, especially when there are two heat-transfer surfaces in the heat sink.

### BRIEF DESCRIPTION OF THE DRAWINGS

Specific embodiments are described in the following detailed description by way of example and with reference to the accompanying drawings, in which:
Fig. 1 is a perspective view of a heat sink;
Fig. 2 is a perspective view of an upper part of the heat sink shown in Fig. 1;
Fig. 3 is a longitudinal sectional view of the upper part shown in Fig. 2;
Fig. 4 is a perspective view of a lower part of the heat sink shown in Fig. 1;
Fig. 5 is a longitudinal sectional view of the lower part shown in Fig. 4;
Fig. 6 is a perspective view of a cross section of the heat sink shown in Fig. 1;
Fig. 7 is a cross sectional view of the heat sink shown in Fig. 1;
Fig. 8 is a longitudinal sectional view of the heat sink shown in Fig. 1;
Fig. 9 is a partial view of a longitudinal section of the heat sink shown in Fig. 1 illustrating an overlap between an upper part cavity and a lower part cavity of a coolant channel;
Fig. 10 is a perspective view of the heat sink shown in Fig. 1 with a partial cross section and a longitudinal section illustrating coolant paths from an inlet manifold to an outlet manifold; and Fig. 11 is a perspective view of the lower part shown in Fig. 4 also illustrating the coolant paths.

### DETAILED DESCRIPTION

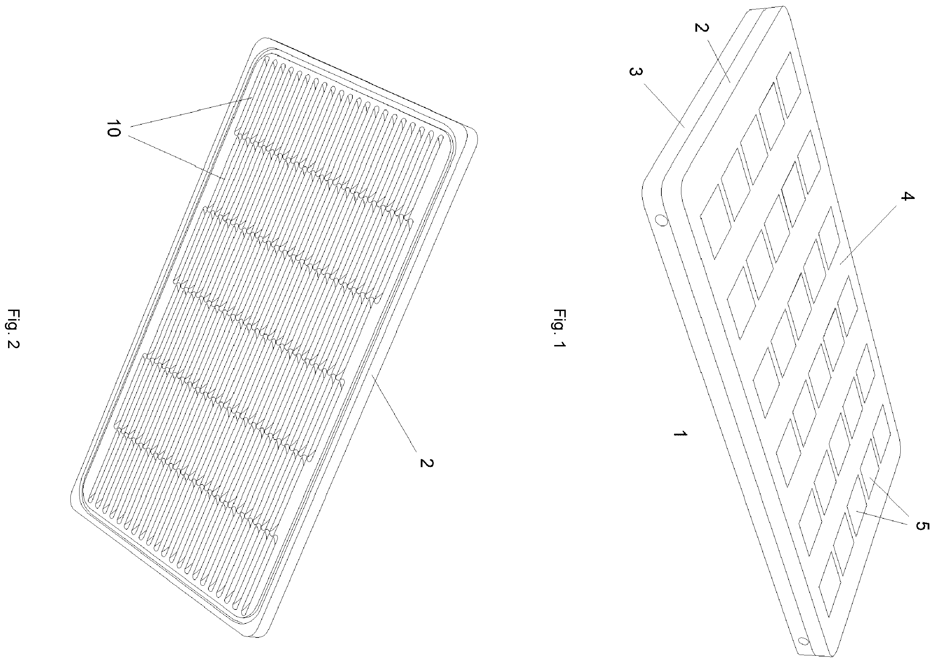

Fig. 1 illustrates a perspective view of a heat sink 1. The heat sink 1 is designed for cooling a power board of an inverter including 30 IGBTs (not shown). The heat sink 1 includes an upper part 2 and a lower part 3. The upper part 2 has a heat-transfer surface 4 including 30 heat-transferring spots 5 that represent points of contact of the heat-transfer surface 4 with the said 30 IGBTs. In some embodiments, the lower part 3 of the heat sink 1 can have another heat-transfer surface. The present disclosure is not restricted in this regard and all the benefits thereof will occur irrespectively of the number of heat-transfer surfaces in the heat sink 1.

The upper and lower parts of the heat sink 1 may comprise plates made of aluminum, stainless steel or any other appropriate material. At that, the upper and lower parts of the heat sink 1 can be made of different materials, for example, the upper part 2, having the heat-transfer surface 4, can be made of aluminum or another metal while the lower part 3, not having a heat-transfer surface, can be made of heat resistant plastic such as polypropylene to reduce the weigh and cost of the heat sink 1.

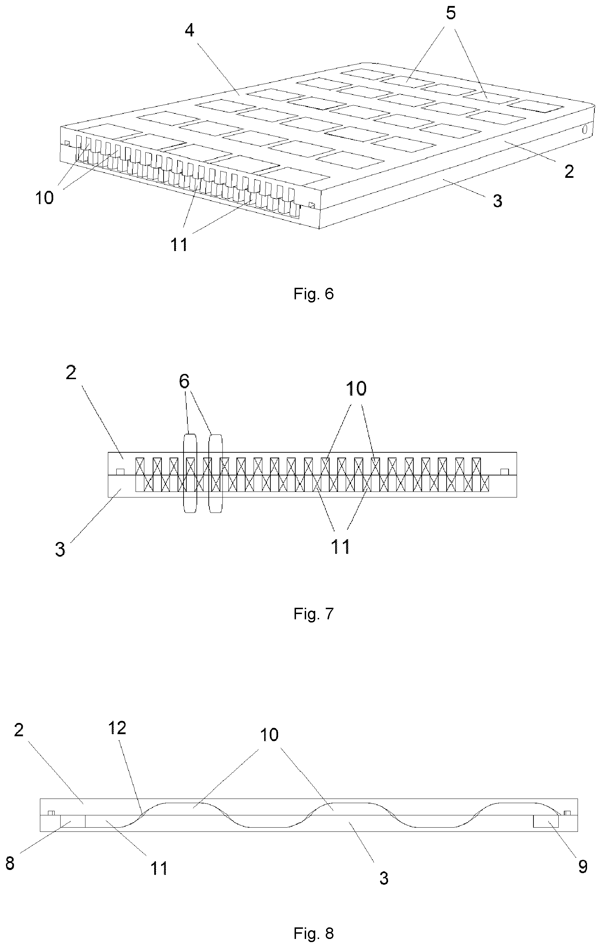

Moreover, the parts of the heat sink 1 can be made in one piece or consist of sub-parts which, in turn, can be made of any appropriate materials depending on desired characteristics of the heat sink 1. The upper and lower parts of the heat sink 1 as well as any sub-parts thereof can be produced by molding, extrusion, cutting or any other applicable production method. Furthermore, the present disclosure is not restricted in regard of a shape of the heat sink parts, for example, the heat sink parts can be curved to bend round a cylindrical electric motor for cooling thereof with the same benefits. The upper part 2 and the lower part 3 of the heat sink 1 can be connected to each other by any appropriate connecting means, either in a separable manner, for example, by screws or clips, or permanently, for example, by gluing or welding. With reference to Figs. 2, 4, 6 and 7, the heat sink 1 comprises 42 coolant channels 6 to enable coolant to flow to transfer heat from the heat-transfer surface 4 and especially from the heat-transferring spots 5. The coolant channels 6 can be made in the course of the heat sink manufacture or formed separately, e.g. by extrusion, cutting or any other applicable tooling method. The number of the coolant channels 6 can vary depending on desired characteristics of the heat sink 1, preferably, providing that each heat-transferring spot 5 extends across at least two coolant channels 6 adjacent to each other in the transverse direction of the heat sink 1. Though, the present disclosure is not restricted in regard the number of the coolant channels 6 and the benefits of the disclosure will occur irrespectively of said parameter. As illustrated in Figs. 8 to 11, each of the coolant channels 6 defines non-linear in its longitudinal section path 7 for coolant flow from an inlet manifold 8 to an outlet manifold 9.

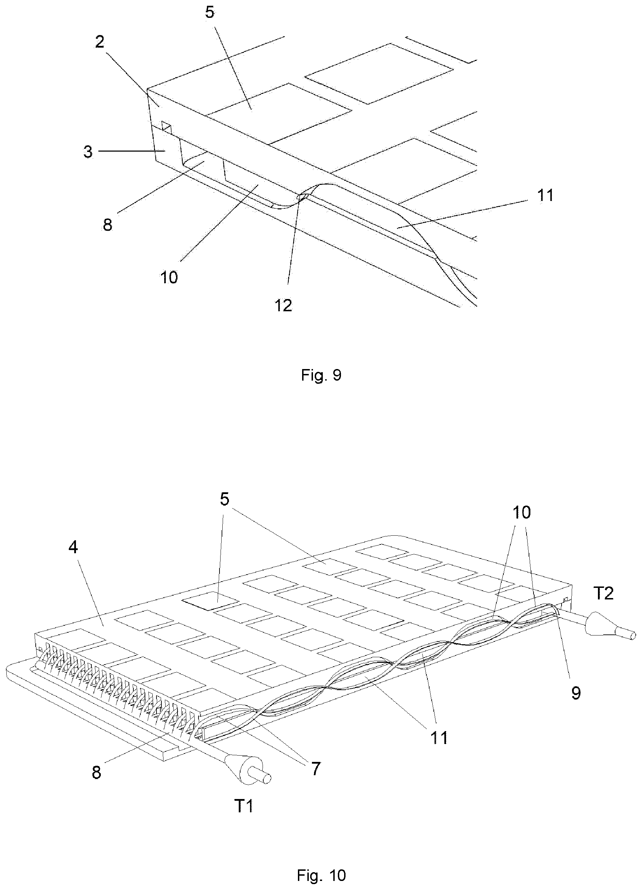

In particular, with reference to Figs. 8 to 10, each of the coolant channels 6 includes cavities 10 and 11 formed alternatingly in the upper part 2 (hereinafter - the upper part cavities 10) and the lower part 3 (hereinafter - the lower part cavities 11) of the heat sink 1. To form a path for the coolant flow, the upper part cavities 10 and the lower part cavities 11 in every coolant channel 6 are successively connected to each other by its overlapping sides. The overlaps 12 between the successive cavities 10 and 11 are illustrated in Figs. 8 and 9. The overlaps 12 have smaller cross-sectional area than the cavities 10 and 11, thereby, the overlaps 12 in a coolant channel 6 define a hydraulic flow resistance thereof.

Due to the disclosed design of the coolant channels 6, the coolant is brought into contact with the heat-transfer surface 4, in particular with the said 30 heat-transferring spots 5, when it propagates through the upper part cavities 10 of the coolant channels 6, while in the lower part cavities 11 the coolant flow transfers a part of the collected heat to the lower part 3 of the heat sink 1, further to the coolant flows in the adjacent channels 6 and so on. At that, the overlaps 12, having smaller cross-sectional area than the cavities 10 and 11, operate as nozzles increasing the coolant flow velocity at the entrance of every cavity 10 and 11 in every coolant channel 6. As a result, the coolant flows are pressed against walls of the cavities in both the upper part cavities 10 and the lower part cavities 11 of the coolant channels 6. It allows avoiding a laminar boundary layer of the coolant flow over the walls of the cavities and increases the heat transfer efficiency.

The overlaps 12 are also designed as flow restrictions defining the hydraulic resistance of the coolant channels 6 so that to enable uniform filing of all the channels 6 by the coolant as well as the same average velocity of the coolant flow in every channel 6. Correspondently, the heat is distributed much more uniformly over the heat sink volume and a difference between an inlet coolant temperature (T1) and an outlet coolant temperature (T2) is decreased significantly.

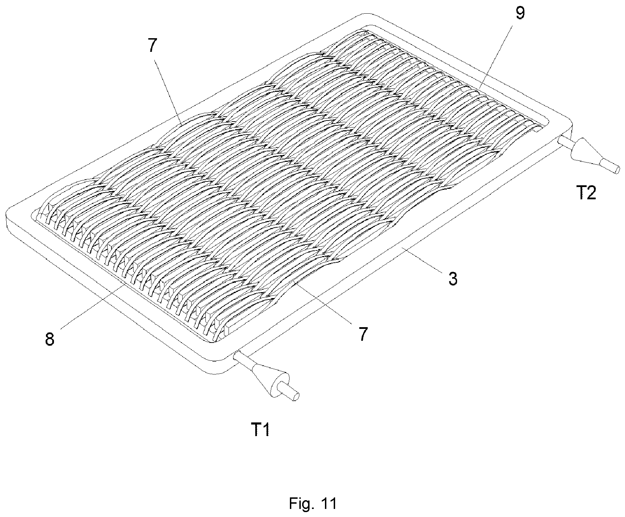

As shown in Figs. 6 and 7, the coolant channels 6 adjacent to each other in the transverse direction of the heat sink 1 are made in an antiphase manner in terms of positions of the upper part cavities 10 and the lower part cavities 11 in a cross section of the heat sink 1. That is, in a cross section of the heat sink 1 the cavities constituting the coolant channels 6 are checkerboard-arranged in the upper part 2 and lower part 3 of the heat sink 1, as shown in Fig.7 (dashed areas in the figure represent cavities constituting the coolant channels 6). Correspondingly, any two coolant channels 6 adjacent to each other in the transverse direction of the heat sink 1 define a pair of antiphase paths 7 of the coolant, in which the coolant flows are in antiphase, as illustrated in Figs. 10 and 11.

As mentioned above, each heat-transferring spot 5 preferably extends across more than two coolant channels 6 adjacent to each other in the transverse direction of the heat sink 1 to be cooled by means of more than one pair of antiphase flows of the coolant. The heat sink 1 as illustrated includes 21 pairs of antiphase coolant channels 6 intended for cooling a matrix of 30 heat-transferring spots 5 arranged in five rows with six spots in every row, i.e. with six columns in every row. Thereby, each heat-transferring spot 5 of the heat sink 1 is cooled by means of 4 pairs of antiphase coolant channels 6 as one can see in Figs. 6 and 10.

It is also preferred to arrange the cavities 10 and 11 of the coolant channels 6 such than to align its positions in the longitudinal direction of the heat sink 1 with positions of the columns of the heat-transferring spots 5, as illustrated in Fig. 10, to enhance cooling of the heat-transferring spots 5. In use of the heat sink 1, each antiphase pair of the coolant channels 6 operates in the following manner in a cross section of the heat sink 1: the coolant flow in one channel, propagating through the upper part cavity 10, is brought into direct contact with a heat-transferring spot 5 and thereby collects the heat from the heat-transfer surface 4; at the same time the coolant flow in the other channel, propagating through the lower part cavity 11, moves away from the heat-transfer surface 4 and transfers a part of the collected heat to the lower part 2 of the heat sink 1. In both cases the heat transfer efficiency is increased due to a local increase of the coolant flow velocity at the entrance of every coolant channel cavity 10 and 11.

There are no intersections between the adjacent coolant channels 6 except for an area of the inlet manifold 8 and the outlet manifold 9. At that, no special sealing is required between the coolant channels 6 since a hydraulic resistance of any minor leakage between the coolant channels 6 would exceed the hydraulic resistance of the channels itself. Optionally, the heat sink 1 can be sealed circumferentially, for example, by means of a sealing gasket arranged in a circumferential groove made in the upper part 2 as shown in Fig. 2. In any case, the heat sink according to the present disclosure requires essentially no maintenance.

With reference to Fig. 7, the coolant channels 6 in the heat sink 1 are made of the same width and adjacent to each other in the transverse direction of the heat sink so that the whole heat-transfer area of the heat sink 1 is occupied therewith. This allows further increasing the heat sink efficiency while keeping its size compact. However, the present disclosure is not restricted in regard the coolant channels' widths and its mutual arrangement and the benefits of the disclosure will occur irrespectively of said parameters. For example, the coolant channels 6 can be spaced from each other and/or grouped with each other in a certain way within the heat sink 1 to provide a desired cooling pattern over the heat-transfer surface 4. In some embodiments the coolant channels 6 can be curvilinear in the plane of the heat sink.

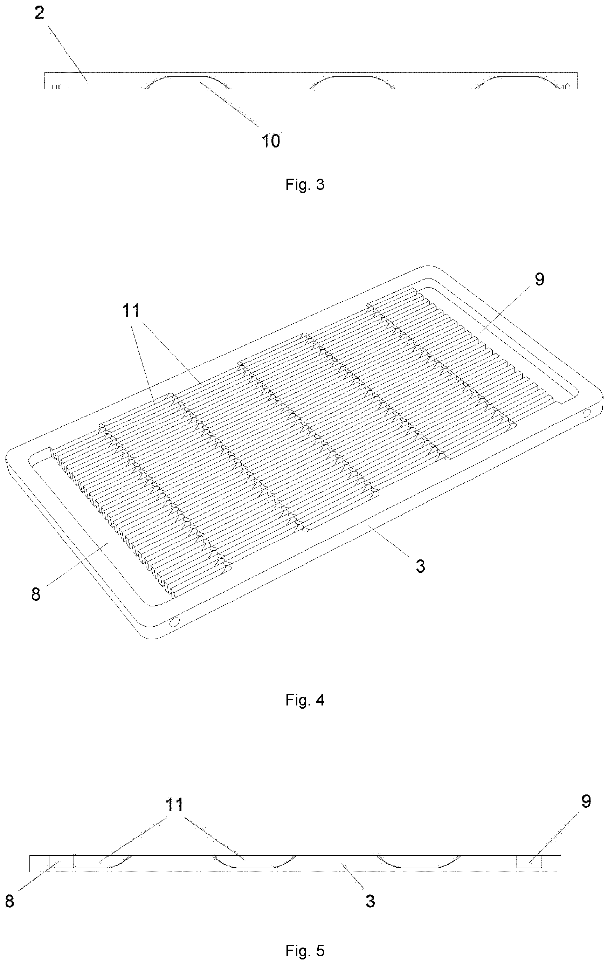

As shown in Figs. 4, 5 8 and 10, the inlet manifold 8 and the outlet manifold 9 comprise cavities formed in the lower part 3 of the heat sink 1 extending in the transverse direction thereof to pass through all the coolant channels 6. In some embodiments the cavities constituting the inlet manifold 8 and the outlet manifold 9 can be formed in the upper part 2 of the heat sink 1, or one of said cavities can be formed in the lower part 3 while the other one - in the upper part 3 of the heat sink 1. Preferably, as shown in Figs. 8 to 11, the cavities constituting the inlet manifold 8 and the outlet manifold 9 are formed in place of (and thereby overlapping) the cavities constituting the coolant channels 6 so that the manifolds 8 and 9 are arranged within the heat-transfer area of the heat sink 1 which allows additionally reducing sizes of the heat sink 1. Though, the present disclosure is not restricted in this regard and its benefits will occur irrespectively of the positioning of the cavities constituting the inlet and outlet manifolds within the heat sink 1.

As shown in Figs. 10 and 11, each of the coolant channels 6 in the heat sink 1 comprises the same number of the upper part cavities 10 and the lower part cavities 11. Such symmetry of the heat sink design simplifies the heat sink manufacture and enhances the heat distribution over the heat sink volume, especially if there are two heat-transfer surfaces in the heat sink. Though, in alternative embodiments the number of the coolant channel cavities in the upper and lower parts of the heat sink may vary, for example, depending on the number or mutual arrangement of to-be cooled IGBTs.

Exemplary embodiments have been disclosed for illustrative purposes only and those skilled in the art will appreciate that various modifications, additions and substitutions are possible, without departing from the scope of the accompanying claims.

## Claims

1. A heat sink including an upper part and a lower part, at least the upper part having a heat-transfer surface, the heat sink comprising multiple coolant channels, each defining a path for a coolant flow from an inlet manifold to an outlet manifold to transfer heat from the heat-transfer surface, wherein each of the coolant channels comprises cavities formed alternatingly in the upper part and the lower part of the heat sink, the cavities being successively connected to each other by overlapping sides thereof, wherein an overlap between any two successive cavities has smaller cross-sectional area than the cavities.

2. The heat sink according to claim 1, wherein the coolant channels adjacent to each other in the transverse direction of the heat sink are made in an antiphase manner so that in a cross section of the heat sink the cavities constituting the coolant channels are checkerboard-arranged in the upper and lower parts of the heat sink.

3. The heat sink according to claim 1 or 2, wherein the coolant channels are made of the same width and adjacent to each other in the transverse direction of the heat sink so that the whole heat-transfer area of the heat sink is occupied therewith.

4. The heat sink according to any of claims 1 to 3, wherein the lower part of the heat sink has another heat-transfer surface.

5. The heat sink according to any of claims 1 to 4, wherein the inlet manifold and the outlet manifold comprise cavities formed in the lower part and/or the upper part of the heat sink extending in the transverse direction thereof to pass through all the coolant channels.

6. The heat sink according to claim 5, wherein the cavities constituting the inlet manifold and the outlet manifold are formed in place of the cavities constituting the coolant channels so that the manifolds are arranged within the heat-transfer area of the heat sink.

7. The heat sink according to any of claims 1 to 6, wherein each of the coolant channels comprises the same number of cavities in the upper part as in the lower part of the heat sink.
